# EUROPEAN PATENT SPECIFICATION

(11) **EP 2 002 468 B1**
(45) Date of publication and mention of the grant of the patent: **24.07.2013**
(21) Application number: 07754621.6
(22) Date of filing: 03.04.2007
(51) Int. Cl.: H01L 29/06, H01L 29/786, H01L 29/66, H01L 29/78, H01L 27/105, H01L 27/108, H01L 29/423

(54) **Nanowire transistor with surrounding gate**
Nanodrahttransistor mit umlaufendem Gate
Transistor à nanofil entouré d'une grille

(30) Priority: 04.04.2006 US 397527; 04.04.2006 US 397430; 04.04.2006 US 397358; 04.04.2006 US 397413; 04.04.2006 US 397406
(43) Date of publication of application: 17.12.2008
(73) Proprietor: Micron Technology, Inc., Boise, ID 83706-9632 (US)
(72) Inventor: FORBES, Leonard, Corvallis, Oregon 97330 (US)
(74) Representative: Maury, Richard Philip
(86) International application number: PCT/US2007/008123
(87) International publication number: WO 2007/120492

(56) References cited:
- DE-A1- 19 943 390
- US-A1- 2005 032 297
- US-A1- 2006 046 391
- US-B1- 6 855 582

## Description

### Cross Reference To Related Applications

Benefit of priority is hereby claimed to "Grown Nanofin Transistors," U.S. Application Serial No. 11/397,430, filed on April 4, 2006; "Etched Nanofin Transistors," U.S. Application Serial No. 11/397,358, filed on April 4, 2006; "DRAM With Nanofin Transistors," U.S. Application Serial No. 11/397,413, filed on April 4, 2006; and "Tunneling Transistor With Sublithographic Channel," U.S. Application Serial No. 11/397,406, filed April 4, 2006.

### Technical Field

This disclosure relates generally to semiconductor devices, and more particularly, to nanowire transistors that have a surrounding gate.

### Background

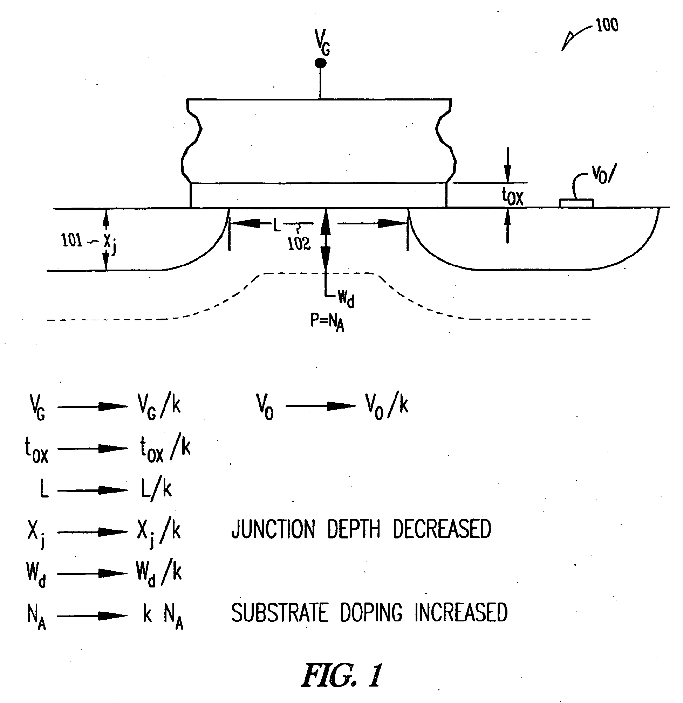

The semiconductor industry has a market driven need to reduce the size of devices, such as transistors, and increase the device density on a substrate. Some product goals include lower power consumption, higher performance, and smaller sizes. FIG. 1 illustrates general trends and relationships for a variety of device parameters with scaling by a factor k. The continuous scaling of MOSFET technology to the deep sub-micron region where channel lengths are less than 0.1 micron (100 nm or 1000 A) causes significant problems in the conventional transistor structures. For example, junction depths should be much less than the channel length. Thus, with reference to the transistor 100 illustrated in FIG. 1, the junctions depths 101 should be on the order of a few hundred Angstroms for channels lengths 102 that are approximately 1000 Å long. Such shallow junctions are difficult to form by conventional implantation and diffusion techniques. Extremely high levels of channel doping are required to suppress short-channel effects such as drain induced barrier lowering, threshold voltage roll off, and sub-threshold conduction. Sub-threshold conduction is particularly problematic in DRAM technology as it reduces the charge storage retention time on the capacitor cells. These extremely high doping levels result in increased leakage and reduced carrier mobility. Thus, the expected improved performance attributed to a shorter channel is negated by the lower carrier mobility and higher leakage attributed to the higher doping.

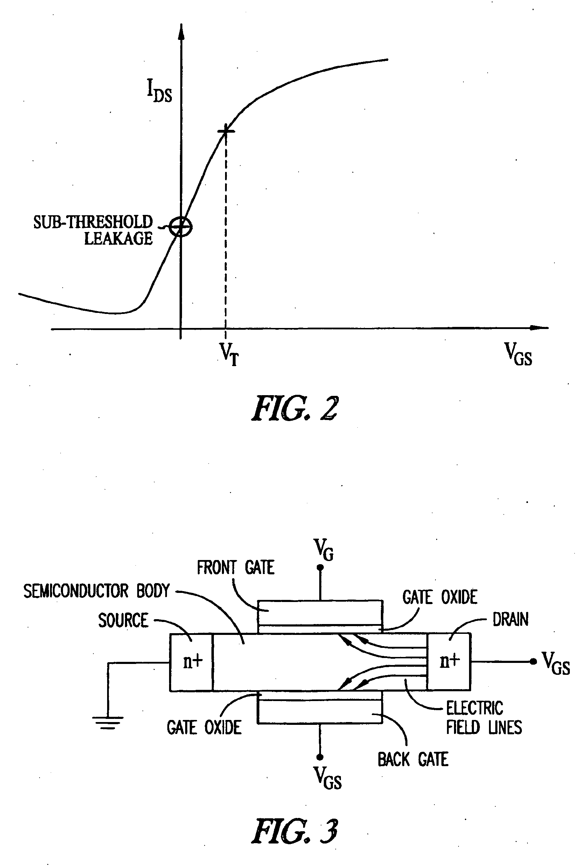

Leakage current is a significant issue in low voltage and lower power battery-operated CMOS circuits and systems, and particularly in DRAM circuits. The threshold voltage magnitudes are small to achieve significant overdrive and reasonable switching speeds. However, as illustrated in FIG. 2, the small threshold results in a relatively large sub-threshold leakage current.

Some proposed designs to address this problem use transistors with ultrathin bodies, or transistors where the surface space charge region scales as other transistor dimensions scale down. Dual-gated or double-gated transistor structures also have been proposed to scale down transistors. As commonly used in the industry, "dual-gate" refers to a transistor with a front gate and a back gate which can be driven with separate and independent voltages, and "double-gated" refers to structures where both gates are driven when the same potential. An example of a double-gated device structure is the FinFET. "TriGate" structures and surrounding gate structures have also been proposed. In the "TriGate" structure, the gate is on three sides of the channel. In the surrounding gate structure, the gate surrounds or encircles the transistor channel. The surrounding gate structure provides desirable control over the transistor channel, but the structure has been difficult to realize in practice.

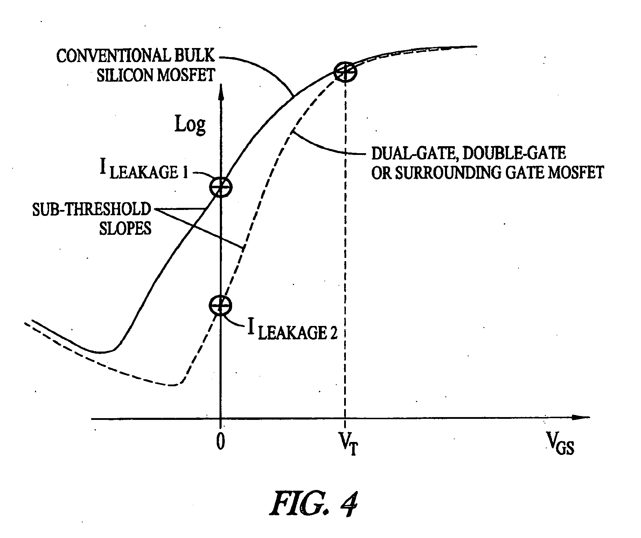

FIG. 3 illustrates a dual-gated MOSFET with a drain, a source, and front and back gates separated from a semiconductor body by gate insulators, and also illustrates an electric field generated by the drain. Some characteristics of the dual-gated and/or double-gated MOSFET are better than the conventional bulk silicon MOSFETs, because compared to a single gate the two gates better screen the electric field generated by the drain electrode from the source-end of the channel. The surrounding gate further screens the electric field generated by the drain electrode from the source. Thus, sub-threshold leakage current characteristics are improved, because the sub-threshold current is reduced more quickly as the gate voltage is reduced when the dual-gate and/or double gate MOSFET turns off. FIG. 4 generally illustrates the improved sub-threshold characteristics of dual gate, double-gate, or surrounding gate MOSFETs in comparison to the sub-threshold characteristics of conventional bulk silicon MOSFETs.

Advances have been made in the growth of II-V compound semiconductor nanowires and in the fabrication of III-V compound semiconductor nanowire transistors. The growth of the II-V compound semiconductor transistors is achieved by vapor-liquid-solid (VLS) epitaxial growth of vertical nanowires on gold dots. Silicon nanowire transistors have been previously described by vapor phase epitaxial growth through a hole or by solid phase epitaxial growth over a polysilicon DRAM capacitor plate to make a polycrystalline nanowire transistor.

US 2005/0032297 discloses a method for forming a transistor including a pillar formed in a nanopore.

### Summary

An embodiment of the present subject matter provides nanowire transistors from amorphous semiconductor nanorods that are recrystallized on the surface of a semiconductor wafer. The silicon nanorods are formed with dimensions smaller than lithographic dimensions by a sidewall spacer technique. The recrystallization of the amorphous nanorods uses solid phase epitaxial growth. The resulting nanowires can be used as the body regions of transistors where both the thickness of the body of the transistor and channel length have dimensions smaller than lithographic dimensions. The nanowire transistors have a wraparound gate. Various nanowire transistor embodiments use silicon nanowires.

One aspect of the present subject matter relates to a method for forming a transistor. According to an embodiment of the method, a pillar of amorphous semiconductor material is formed on a crystalline substrate, and a solid phase epitaxy process is performed to crystallize the amorphous semiconductor material using the crystalline substrate to seed the crystalline growth. The pillar has a sublithographic thickness. A transistor body is formed in the crystallized semiconductor pillar between a first source/drain region and a second source/drain region. A surrounding gate insulator is formed around the semiconductor pillar, and a surrounding gate is formed around and separated from the semiconductor pillar by the surrounding gate insulator.

An aspect relates to a transistor. A transistor embodiment includes a crystalline substrate, a first source/drain region formed in the crystalline substrate, and a crystalline semiconductor pillar formed on the substrate in contact with the first source/drain region. The transistor includes a second source/drain region formed in a top portion of the pillar, a gate insulator formed around the pillar, and a surrounding gate formed around and separated from the pillar by the gate insulator. The pillar has cross-section dimensions less than a minimum feature size.

These and other aspects, embodiments, advantages, and features will become apparent from the following description of the present subject matter and the referenced drawings.

### Brief Description of the Drawings

FIG. 1 illustrates general trends and relationships for a variety of device parameters with scaling by a factor k.
FIG. 2 illustrates sub-threshold leakage in a conventional silicon MOSFET.
FIG. 3 illustrates a dual-gated MOSFET with a drain, a source, front and back gates separated from a semiconductor body by gate insulators, and an electric field generated by the drain.
FIG. 4 generally illustrates the improved sub-threshold characteristics of dual gate, double-gate, or surrounding gate MOSFETs in comparison to the sub-threshold characteristics of conventional bulk silicon MOSFETs.
FIGS. 5A-5H illustrate an embodiment of a process to form crystalline nanorods with surrounding gates.
FIGS. 6A-6C illustrate an embodiment of a process to form isolated transistors with source, drain and gate contacts, using the nanorods with wraparound gates illustrated in FIGS. 5A-5H.
FIGS. 7A-7C illustrate an embodiment of a process to form an array of transistors, using the nanorods with wraparound gates illustrated in FIGS. 5A-5H.
FIG. 8 illustrates a flow diagram for forming a nanowire transistor with surrounding gates, according to various embodiments of the present subject matter.
FIG. 9 is a simplified block diagram of a high-level organization of various embodiments of a memory device according to various embodiments of the present subject matter.
FIG. 10 illustrates a diagram for an electronic system having nanowire transistors, according to various embodiments.
FIG. 11 depicts a diagram of an embodiment of a system having a controller and a memory.

### Detailed Description

The following detailed description refers to the accompanying drawings which show, by way of illustration, specific aspects and embodiments in which the present subject matter may be practiced. These embodiments are described in sufficient detail to enable those skilled in the art to practice the present subject matter. The various embodiments of the present subject matter are not necessarily mutually exclusive as aspects of one embodiment can be combined with aspects of another embodiment. Other embodiments may be utilized and structural, logical, and electrical changes may be made without departing from the scope of the present subject matter. In the following description, the terms "wafer" and "substrate" are interchangeably used to refer generally to any structure on which integrated circuits are formed, and also to such structures during various stages of integrated circuit fabrication. Both terms include doped and undoped semiconductors, epitaxial layers of a semiconductor on a supporting semiconductor or insulating material, combinations of such layers, as well as other such structures that are known in the art. The term "horizontal" as used in this application is defined as a plane parallel to the conventional plane or surface of a wafer or substrate, regardless of the orientation of the wafer or substrate. The term "vertical" refers to a direction perpendicular to the horizontal as defined above. Prepositions, such as "son", "side", "higher", "lower", "over" and "under" are defined with respect to the conventional plane or surface being on the top surface of the wafer or substrate, regardless of the orientation of the wafer or substrate. The following detailed description is, therefore, not to be taken in a limiting sense, and the scope of the present invention is defined only by the appended claims, along with the full scope of equivalents to which such claims are entitled.

The following discussion refers to silicon nanowire transistor embodiments. Those of ordinary skill in the art will understand, upon reading and comprehending this disclosure, how to use the teaching contained herein to form nanowire transistors using other semiconductors.

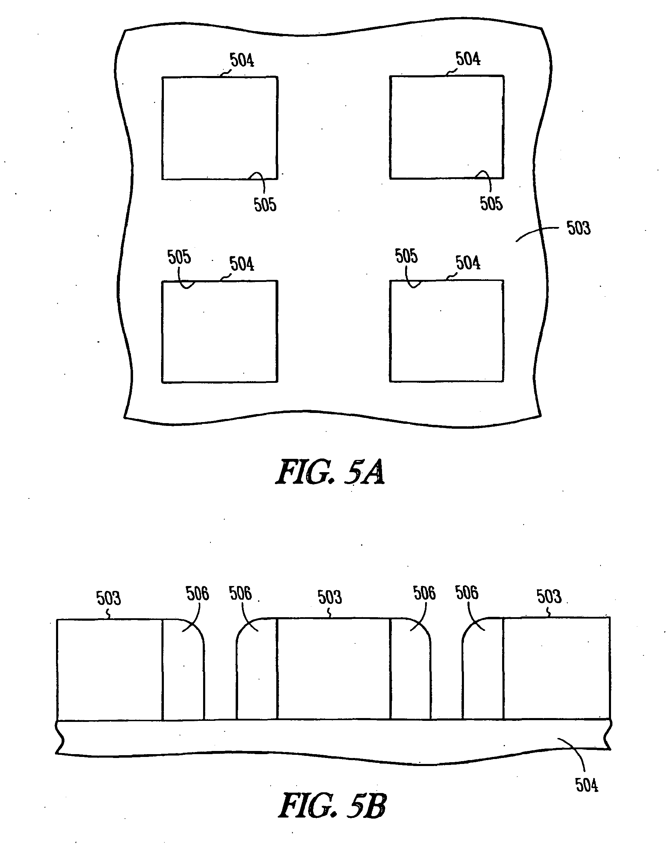

FIGS. 5A-5H illustrate an embodiment of a process to form crystalline nanorods with surrounding gates. FIG. 5A illustrates a first layer 503 on a substrate 504, with holes 505 formed in the first layer. The first layer is able to be etched to define the holes within the layer. According to various embodiments, the holes 505 are formed in a silicon nitride layer 503 on a silicon substrate 504, such that the holes extend through the silicon nitride layer to the silicon substrate. In the illustrated embodiment, the holes are formed with dimensions corresponding to the minimum feature size. The center of each hole corresponds to the desired location of the nanowire transistor. An array of nanowire transistors can have a center-to-center spacing between rows and columns of 2F.

A layer of oxide is provided to cover the first layer after the holes have been etched therein. Various embodiments form a silicon oxide over the silicon nitride layer. Some embodiments deposit the silicon oxide by a chemical vapor deposition (CVD) process.

FIG. 5B illustrates the structure after the oxide is directionally etched to leave oxide sidewalls 506 on the sides of the hole, which function to reduce the dimensions of the resulting hole, and the resulting structure is planarized. In 100 nm technology, for example, the oxide sidewalls reduce the dimensions of the hole to about 30 nm. In this example, the thickness of the body region for the transistor will be on the order of 1/3 of the feature size. Some embodiments planarize the structure using a chemical mechanical polishing (CMP) process.

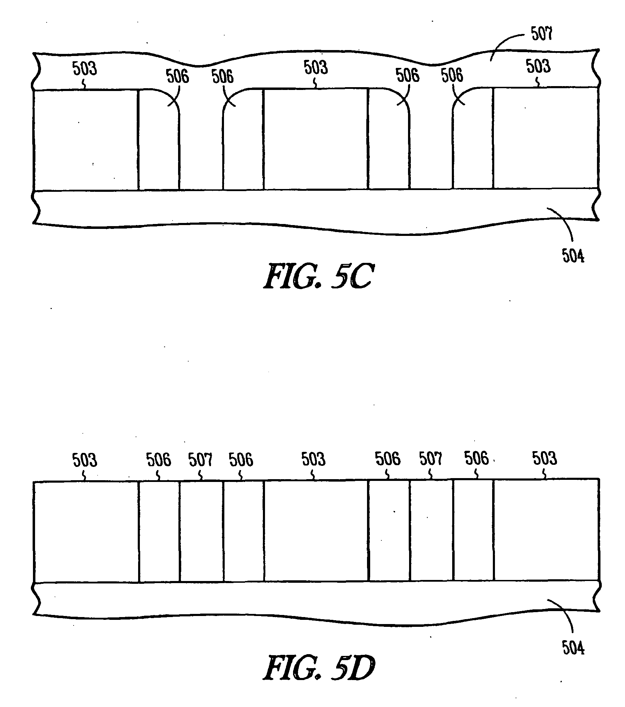

FIG. 5C illustrates a thick layer of an amorphous semiconductor material 507 formed over the resulting structure. The amorphous material fills the hole defined by the sidewalls 506. Various embodiments deposit amorphous silicon as the amorphous material. FIG. 5D illustrates the resulting structure after it is planarized, such as by CMP, to leave amorphous semiconductor material only in the holes.

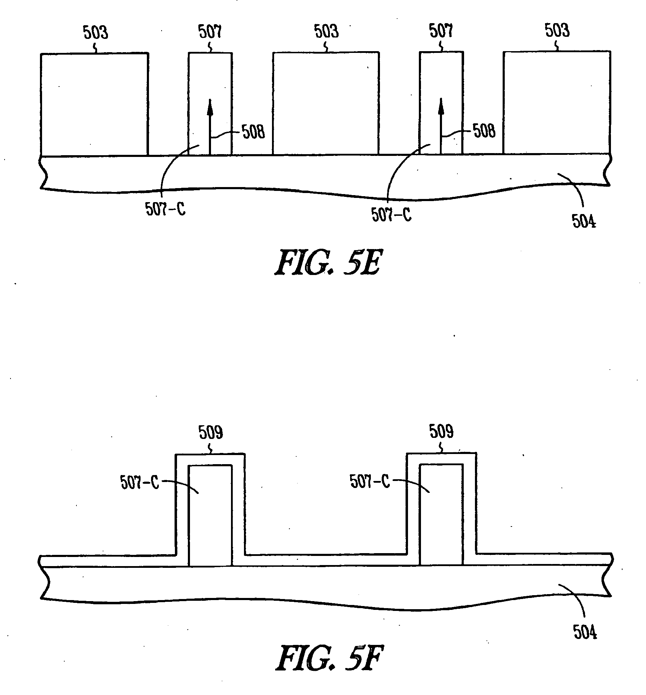

FIG. 5E illustrates the resulting structure after the sidewalls (e.g. silicon oxide sidewalls) are removed. The structure is heat treated to crystallize the amorphous semiconductor 507 (e.g. a-silicon) into crystalline nanorods (represented as 507-C) using a process known as solid phase epitaxy (SPE). The amorphous semiconductor pillar 507 is in contact with the semiconductor wafer (e.g. silicon wafer), and crystal growth in the amorphous semiconductor pillar its seeded by the crystals in the wafer. The crystal formation from the SPE process is illustrated by the arrows 508 in FIG. 5E.

FIG. 5F illustrates the structure after the first layer (e.g. silicon nitride) is removed, leaving crystalline nanorods 507-C extending away from the substrate surface, and after a gate insulator 509 is formed over the resulting structure. An embodiment forms the gate insulator by a thermal oxidation process. Thus, for an embodiment in which the wafer is a silicon wafer and the nanorods are crystalline silicon nanorods, the gate insulator is a silicon oxide. Other gate insulators, such as high K insulators, may be used.

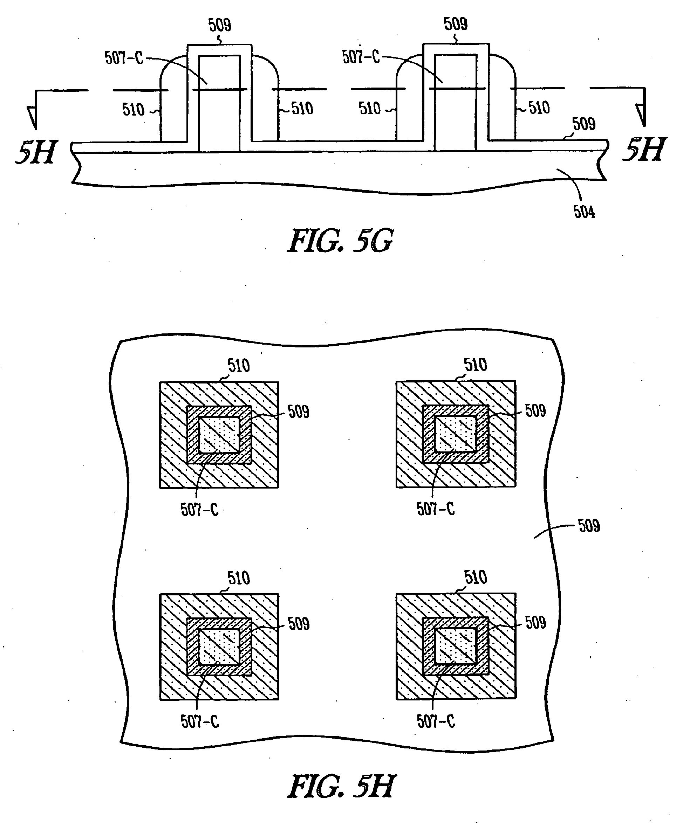

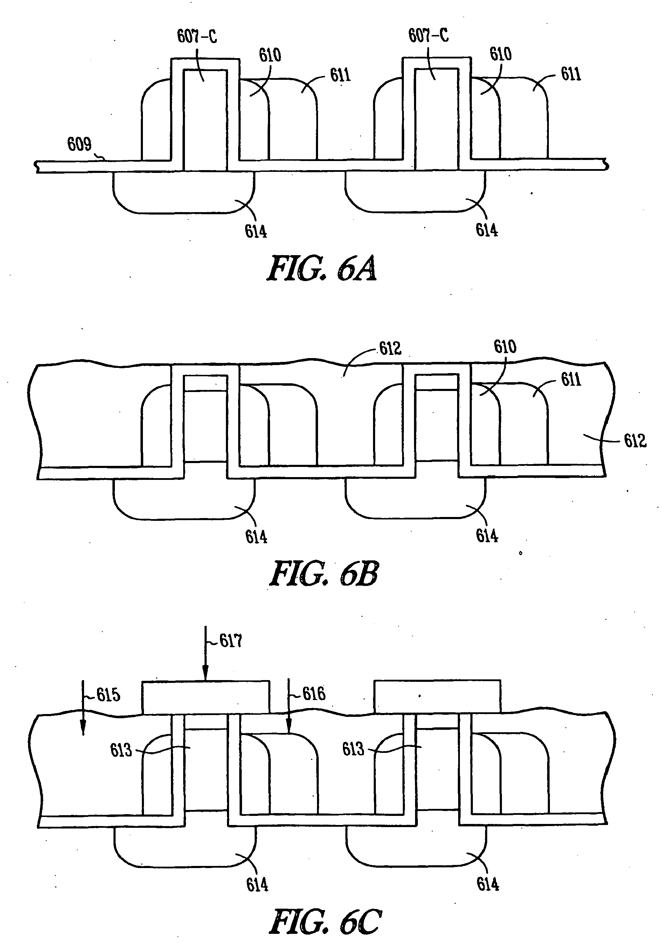

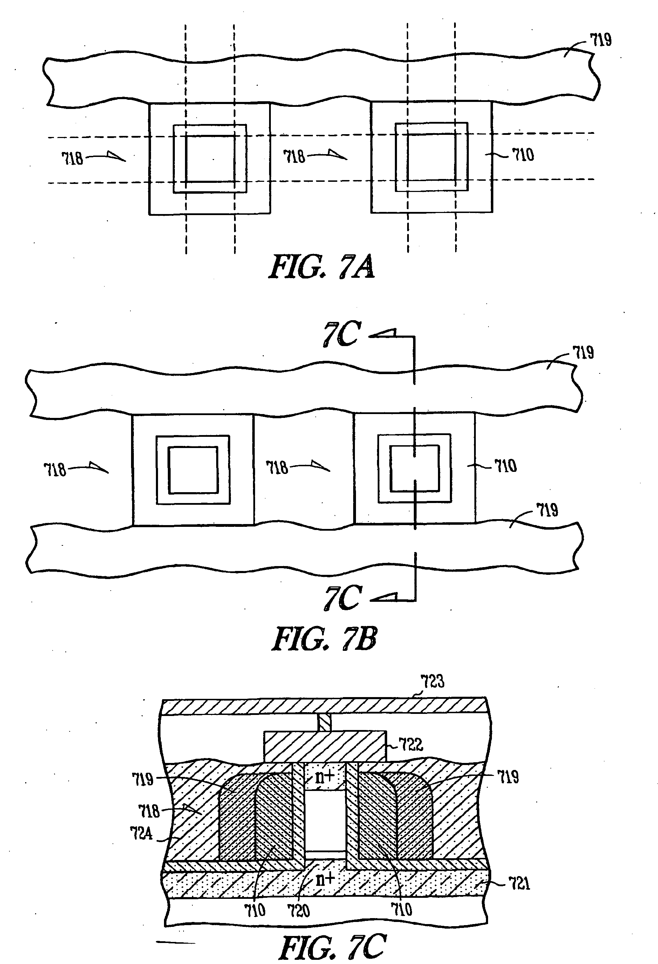

FIG. 5G illustrates a side view and FIG. 5H illustrates a cross-section view along 5H-5H of FIG. 5G view of the structure after a gate material 510 is formed on the sidewalls of the crystalline nanorods 507-C. An embodiment deposits the gate material and etches the resulting structure to leave the gate material only on the sidewalls of the nanorods. Polysilicon is used as the gate material, according to various embodiments. The height of the pillars, which determines the channel length of the transistors, can be less than the minimum lithographic dimensions. Various embodiments provide a channel length on the order of approximately 100 nm. These nanorods with wraparound gates can be used to form nanowire transistors with surrounding or wraparound gates. The process continues in FIGS. 6A-6C for some embodiments of standalone transistors, and continued in FIGS. 7A-7C for some embodiments of transistor arrays.

FIGS. 6A-6C illustrate an embodiment of a process to form isolated transistors with source, drain and gate contacts, using the nanorods with wraparound gates illustrated in FIGS. 5A-5H. The illustrated structure includes a crystalline nanorod 607-C, a gate insulator 609, and a surrounding gate 610. Gate contacts 611 for the wraparound gates are patterned. Various embodiments deposit polysilicon to function as gate contacts for the wraparound gates. Both the wraparound gate and the gate contact, also referred to as a gate pad, are recessed below the top of the nanowire. A directional etching process may be used to recess the wraparound gate and the gate pad. As illustrated in FIG. 6B, the resulting structure is filled with an insulator fill (e.g. oxide) 612 and planarized to the top of the nanowires. The top of the nanowires are exposed by removing the gate insulator from the top of the nanowire. For example, an etch can be used to remove silicon oxide from the top of the nanowire. The top of the nanowires can be doped and contact areas defined. The doped top portion 613 of the nanowires can function as a drain region. The substrate is appropriately doped to diffuse under the crystalline nanorod, and extend up into a bottom portion of the nanorod. This doped region can function as a source region. This doped region 614 also extends to a contact area. The doped region can be formed before the first layer is deposited and holes formed therein. The dopant can also be implanted and diffused before the surrounding gate is formed. Appropriate doping can be provided to provide NMOS or PMOS transistors. As illustrated in FIG. 6C, a contact 615 can be etched to the buried source, a contact 616 can be etched to the buried gate pad, and a contact 617 can also be formed for the drain. Those of ordinary skill in the art will understand, upon reading and comprehending this disclosure, that other stand alone transistor designs may be used.

FIGS. 7A-7C illustrate an embodiment of a process to form an array of transistors, using the nanorods with wraparound gates illustrated in FIGS. 5A-5H. FIG. 7A illustrates a top view of adjacent transistors in a row of an embodiment of a transistor array. According to the illustrated embodiment, one word line 719 is formed adjacent to one row of transistors, such that the wraparound gates 710 of each transistor 718 in the row are in contact with the adjacent word line. FIB. 7B illustrates a top view of adjacent transistors in a row of another embodiment of a transistor array. According to various embodiments, polysilicon or gate material can be used for the gate wiring, a buried doped region can form a source region 720 and the source wiring 721, and metal contacts 722 and metal used for the drain wiring 723. In some embodiments, the nanowire structure with only wraparound gates is then backfilled with oxide and patterned and etched to leave oxide 724 between the pillars in one direction and expose the wrap around gates on the side. Polysilicon can be deposited and directionally etched to leave only on the sidewalls of the oxide blocks and exposed gate sides. As described with respect to FIG. 6C, the wraparound gates can be further directionally etched to recess them below the top of the nanowire transistors. This will form the gate contacts and wiring. The structure can be planarized and backfilled with oxide and the top of the nanowires doped and contacted for the drain wiring using conventional techniques. Those of ordinary skill in the art will understand, upon reading and comprehending this disclosure, that other transistor array designs may be used.

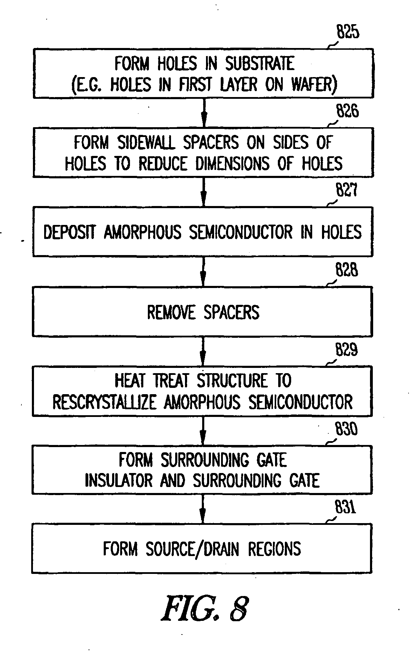

FIG. 8 illustrates a flow diagram for forming a nanowire transistor with surrounding gates, according to various embodiments of the present subject matter.

At 825, holes are formed in a substrate. For example, the substrate can include a first layer on a wafer, such as a layer of silicon nitride on a silicon wafer, and the holes are formed in the first layer to expose the wafer. The holes are defined by walls formed by the first layer. At 826, spacer sidewalls are formed within the holes against the walls formed by the first layer to effectively reduce the dimensions of the holes. An example of a spacer sidewall is silicon oxide. At 827, the holes are filled by an amorphous semiconductor (e.g. a-silicon). The spacer sidewalls are removed at 828, leaving pillars of amorphous semiconductor extending away from the wafer. The resulting structure is heat-treated or annealed at 829 to recrystallize the amorphous semiconductor, using the wafer to seed the crystalline growth. The recrystallization process is referred to as solid phase epitaxy (SPE). The resulting structure includes crystalline nanowires extending away from the wafer. At 830, a surrounding gate insulator and a surrounding gate are formed around the crystalline nanowires. Source/drain regions are formed at 831. The bottom of the nanowire is doped to form a first source/drain region, and the top of the nanowire is doped to form a second source/drain region. The first source/drain region can be formed by doping the substrate before depositing the first layer and patterning and etching the holes. The first source/drain can also be formed by implanting dopants adjacent to the nanorod before the gate is formed. These implanted dopants are capable of diffusing completely under the nanorod because the nanorods are very thin. This doping can be performed after the first layer is removed off of the substrate.

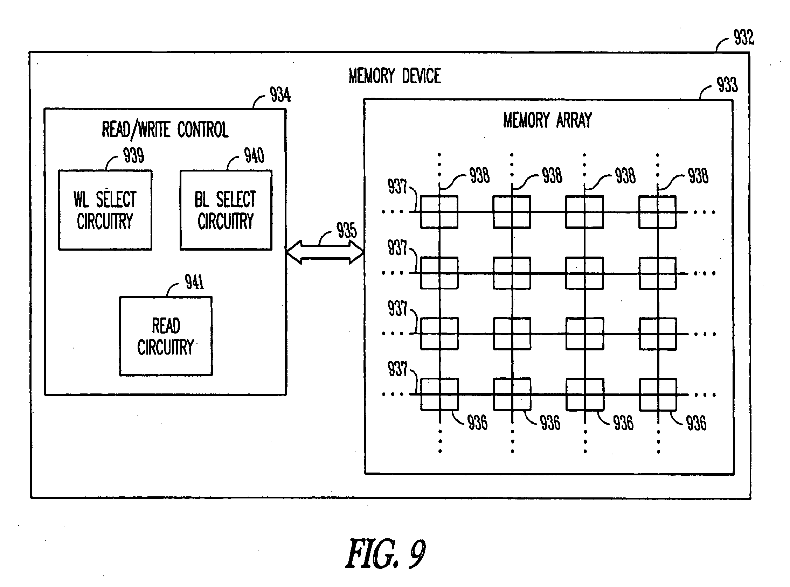

FIG. 9 is a simplified block diagram of a high-level organization of various embodiments of a memory device according to various embodiments of the present subject matter. The illustrated memory device 932 includes a memory array 933 and read/write control circuitry 934 to perform operations on the memory array via communication line(s) or channel(s) 935. The illustrated memory device 932 may be a memory card or a memory module such as a single inline memory module (SIMM) and dual inline memory module (DIMM). One of ordinary skill in the art will understand, upon reading and comprehending this disclosure, that semiconductor components in the memory array and / or the control circuitry are able to be fabricated using the nanowire transistors with surrounding gates, as described above. The structure and fabrication methods for these devices have been described above.

The memory array 933 includes a number of memory cells 936. The memory cells in the array are arranged in rows and columns. In various embodiments, word lines 937 connect the memory cells in the rows, and bit lines 938 connect the memory cells in the columns. The read/write control circuitry 934 includes word line select circuitry 939 which functions to select a desired row, bit line select circuitry 940 which functions to select a desired column, and read circuitry 941 which functions to detect a memory state for a selected memory cell in the memory array 933.

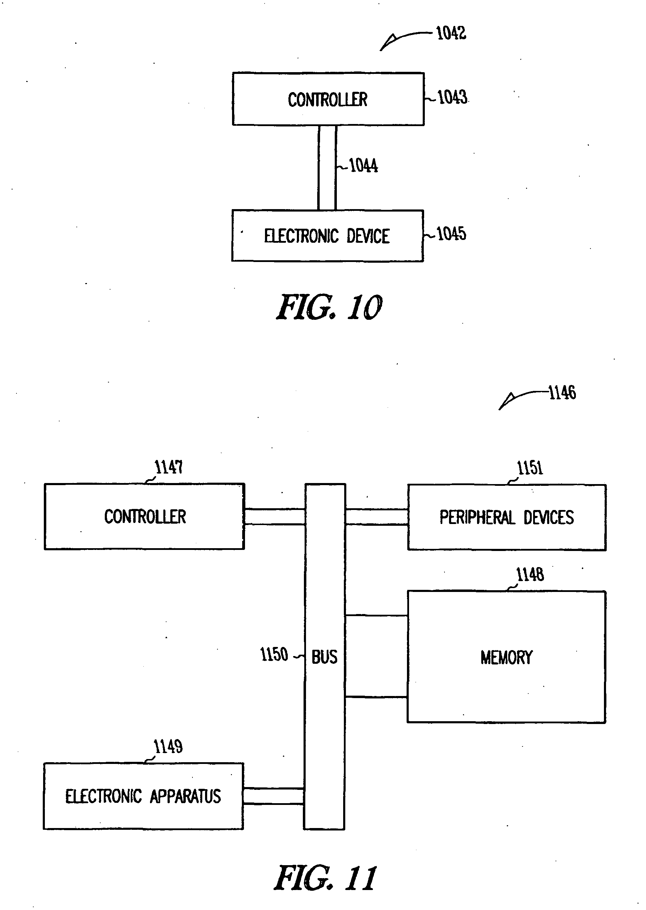

FIG. 10 illustrates a diagram for an electronic system 1042 having one or more nanowire transistors with surrounding gates, according to various embodiments. The electronic system includes a controller 1043, a bus 1044, and an electronic device 1045, where the bus provides communication channels between the controller and the electronic device. In various embodiments, the controller and/or electronic device include nanowire transistors as previously discussed herein. The illustrated electronic system may include, but is not limited to, information handling devices, wireless systems, telecommunication systems, fiber optic systems, electro-optic systems, and computers.

FIG. 11 depicts a diagram of an embodiment of a system 1146 having a controller 1147 and a memory 1148. The controller and/or memory may include nanowire transistors. The illustrated system also includes an electronic apparatus 1149 and a bus 1150 to provide communication channel(s) between the controller and the electronic apparatus, and between the controller and the memory. The bus may include an address, a data bus, and a control bus, each independently configured; or may use common communication channels to provide address, data, and/or control, the use of which is regulated by the controller. In an embodiment, the electronic apparatus 1149 may be additional memory configured similar to memory 1148. An embodiment may include a peripheral device or devices 1151 coupled to the bus. Peripheral devices may include displays, additional storage memory, or other control devices that may operate in conjunction with the controller and/or the memory. In an embodiment, the controller is a processor. Any of the controller, the memory, the electronic apparatus, and the peripheral devices may include nanowire transistors. The system may include, but is not limited to, information handling devices, telecommunication systems, and computers. Applications containing nanowire transistors as described in this disclosure include electronic systems for use in memory modules, device drivers, power modules, communication modems, processor modules, and application-specific modules, and may include multilayer, multichip modules. Such circuitry can further be a subcomponent of a variety of electronic systems, such as a clock, a television, a cell phone, a personal computer, an automobile, an industrial control system, an aircraft, and others.

The memory may be realized as a memory device containing nanowire transistors according to various embodiments. It will be understood that embodiments are equally applicable to any size and type of memory circuit and are not intended to be limited to a particular type of memory device. Memory types include a DRAM, SRAM (Static Random Access Memory) or Flash memories. Additionally, the DRAM could be a synchronous DRAM commonly referred to as SGRAM (Synchronous Graphics Random Access Memory), SDRAM (Synchronous Dynamic Random Access Memory), SDRAM II, and DDR SDRAM (Double Data Rate SDRAM). Various emerging memory technologies are capable of using nanowire transistors.

This disclosure includes several processes, circuit diagrams, and structures. The present subject matter is not limited to a particular process order or logical arrangement.

The scope of the present subject matter should be determined with reference to the appended claims, along with the full scope of equivalents to which such claims are entitled.

## Claims

1. A method for forming a transistor, comprising:
forming a transistor body, including:
forming a pillar of amorphous semiconductor material on a crystalline
substrate, the pillar having a sublithographic thickness; and performing a solid phase epitaxy, SPE, process to crystallize the
amorphous semiconductor material using the crystalline substrate to seed the crystalline growth, the transistor body being formed in the crystallized semiconductor pillar between a first source/drain region and a second source/drain region;
forming a surrounding gate insulator around the semiconductor pillar; and
forming a surrounding gate around and separated from the semiconductor pillar by the surrounding gate insulator.

2. The method according to claim 1, wherein forming a pillar of amorphous semiconductor material on a crystalline substrate includes forming a pillar of amorphous silicon on a crystalline silicon substrate.

3. The method according to claim 1 or claim 2, further comprising recessing the surrounding gate such that the surrounding gate has a height less than a height of the pillar.

4. The method according to any one of claims 1 to 3, further comprising forming the first source/drain region in the substrate and forming the second source/drain region in a top portion of the pillar.

5. The method according to any one of claims 1 to 4, wherein forming the pillar of amorphous semiconductor material includes:
forming silicon nitride on a silicon wafer;
etching a hole in the silicon nitride, the hole having a minimum feature size and
extending through the silicon nitride to the silicon wafer;
reducing a dimension of the hole to less than the minimum feature size, including forming silicon oxide sidewall spacers on sides of the silicon nitride that define the hole;
filling the hole with an amorphous silicon; and
removing the silicon oxide sidewall spacers to leave an amorphous silicon pillar in contact with and extending from the wafer.

6. The method according to claim 5, wherein forming a surrounding gate insulator includes oxidizing the crystalline silicon pillar.

7. The method according to any one of claims 1 to 6, wherein the height of the pillar is less than the minimum feature size.

8. A semiconductor structure which is an intermediate product of the method of any preceding claim, comprising:
a crystalline substrate; and
a semiconductor pillar formed on the substrate in contact with the first source/drain region, the semiconductor pillar having cross-section dimensions less than a minimum feature size, the semiconductor pillar having a crystallized bottom portion and an amorphous top portion indicative of a partially-completed solid phase epitaxy, SPE, process.

9. The structure according to claim 8, further comprising a silicon nitride layer on the substrate, the silicon nitride layer being separated from the pillar by a void.

## Patentansprüche

1. Verfahren zur Bildung eines Transistors, umfassend:
Bildung eines Transistorkörpers, darin eingeschlossen:
Bildung eines Pfeilers aus amorphem Halbleitermaterial auf einem kristallinen Substrat, wobei der Pfeiler eine sublithographische Dicke aufweist; und
Durchführung eines Festphasenepitaxie-, SPE-, Prozesses, um das amorphe Halbleitermaterial unter Verwendung des kristallinen Substrats zu kristallisieren, um das Kristallwachstum zu impfen, wobei der Transistorkörper in der kristallisierten Halbleitersäule gebildet ist, zwischen einem ersten Source-/Drainbereich und einem zweiten Source-/Drainbereich;
Bildung eines umlaufenden Gate-Isolators um die Halbleitersäule; und
Bildung eines umlaufenden Gates um die und getrennt von der Halbleitersäule durch den umlaufenden Gate-Isolator.

2. Verfahren nach Anspruch 1, wobei die Bildung eines Pfeilers aus amorphem Halbleitermaterial auf einem kristallinen Substrat die Bildung einer Säule aus amorphem Silizium auf einem kristallinen Siliziumsubstrat umfasst.

3. Verfahren nach Anspruch 1 oder Anspruch 2, weiter umfassend das Eindrücken des umlaufenden Gates, so dass das umlaufende Gate eine Höhe aufweist, die geringer als eine Höhe der Säule ist.

4. Verfahren nach einem der Ansprüche 1 bis 3, weiter umfassend die Bildung des ersten Source-/Drainbereichs im Substrat und Bildung des zweiten Source-/Drainbereichs in einem oberen Abschnitt der Säule.

5. Verfahren nach einem der Ansprüche 1 bis 4, wobei die Bildung der Säule aus amorphem Halbleitermaterial Folgendes umfasst:
Bildung eines Siliziumnitrids auf einem Siliziumwafer,
Ätzen eines Lochs in das Siliziumnitrid, wobei das Loch eine minimale Merkmalgröße aufweist, und
sich durch das Siliziumnitrid bis zum Siliziumwafer erstreckt;
Reduzierung einer Dimension des Lochs auf weniger als die minimale Merkmalgröße, darin eingeschlossen die Bildung von Seitenwandabstandshaltern aus Siliziumoxid auf Seiten des Siliziumnitrids, die das Loch definieren.
Füllung des Lochs mit einem amorphen Silizium; und
Entfernung der Seitenwandabstandshalter aus Siliziumoxid, um eine Säule aus amorphem Silizium in Kontakt mit und sich erstreckend von dem Wafer zu belassen.

6. Verfahren nach Anspruch 5, wobei die Bildung eines umlaufenden Gate-Isolators die Oxidierung der Säule aus kristallinem Silizium umfasst.

7. Verfahren nach einem der Ansprüche 1 bis 6, wobei die Höhe der Säule geringer als die minimale Merkmalgröße ist.

8. Halbleiterstruktur, die ein Zwischenprodukt des Verfahrens nach einem der vorhergehenden Ansprüche ist, umfassend:
ein kristallines Substrat; und
eine Halbleitersäule, gebildet auf dem Substrat in Kontakt mit dem ersten Source-/Drainbereich, wobei die Halbleitersäule Querschnittsabmessungen aufweist, die geringer als eine minimale Merkmalgröße sind, wobei die Halbleitersäule einen kristallisierten unteren Abschnitt und einen amorphen oberen Abschnitt aufweist, die einen teilweise vervollständigten Festphasenepitaxie-, SPE-, Prozess angeben.

9. Struktur nach Anspruch 8, weiter umfassend eine Schicht aus Siliziumnitrid auf dem Substrat, wobei die Schicht aus Siliziumnitrid von der Säule durch eine Lücke getrennt ist.

## Revendications

1. Procédé de formation d'un transistor, comprenant :
la formation d'un corps de transistor, comprenant :
la formation d'un pilier de matériau semi-conducteur amorphe sur un substrat cristallin, le pilier ayant une épaisseur sous-lithographique ; et
l'exécution d'un processus d'épitaxie en phase solide, SPE, pour cristalliser le matériau semi-conducteur amorphe en utilisant le substrat cristallin comme germe de croissance cristalline, le corps de transistor étant formé dans le pilier semi-conducteur cristallisé entre une première région de source/drain et une deuxième région de source/drain ;
la formation d'un isolant de grille entourant le pilier semi-conducteur; et
la formation d'une grille entourant le pilier semi-conducteur et séparée de celui-ci par l'isolant de grille entourant le pilier.

2. Procédé selon la revendication 1, dans lequel la formation d'un pilier de matériau semi-conducteur amorphe sur un substrat cristallin comprend la formation d'un pilier de silicium amorphe sur un substrat en silicium cristallin.

3. Procédé selon la revendication 1 ou la revendication 2, comprenant en outre l'enfoncement de la grille entourant le pilier de sorte que la grille entourant le pilier ait une hauteur inférieure à une hauteur du pilier.

4. Procédé selon l'une quelconque des revendications 1 à 3, comprenant en outre la formation de la première région de source/drain dans le substrat et la formation de la deuxième région de source/drain dans une partie supérieure du pilier.

5. Procédé selon l'une quelconque des revendications 1 à 4, dans lequel la formation du pilier de matériau semi-conducteur amorphe comprend:
la formation d'un nitrure de silicium sur une tranche de silicium,
la gravure d'un trou dans le nitrure de silicium, le trou ayant une taille de caractéristique minimum et
s'étendant à travers le nitrure de silicium jusqu'à la tranche de silicium;
la réduction d'une dimension du trou à une valeur inférieure à la taille de caractéristique minimum, comprenant la formation d'éléments d'espacement des parois latérales en oxyde de silicium sur les côtés du nitrure de silicium qui définissent le trou ;
le remplissage du trou avec du silicium amorphe ; et
le retrait des éléments d'espacement des parois latérales en oxyde de silicium pour laisser un pilier de silicium amorphe en contact avec la tranche et s'étendant de celle-ci.

6. Procédé selon la revendication 5, dans lequel la formation d'un isolant de grille entourant le pilier comprend l'oxydation du pilier de silicium cristallin.

7. Procédé selon l'une quelconque des revendications 1 à 6, dans lequel la hauteur du pilier est inférieure à la taille de caractéristique minimum.

8. Structure semi-conductrice qui est un produit intermédiaire du procédé selon l'une quelconque des revendications précédentes, comprenant :
un substrat cristallin ; et
un pilier semi-conducteur formé sur le substrat en contact avec la première région de source/drain, le pilier semi-conducteur ayant des dimensions transversales inférieures à une taille de caractéristique minimum, le pilier semi-conducteur ayant une partie inférieure cristallisée et une partie supérieure amorphe indicatives d'un processus d'épitaxie en phase solide, SPE, partiellement achevé.

9. Structure selon la revendication 8, comprenant en outre une couche de nitrure de silicium sur le substrat, la couche de nitrure de silicium étant séparée du pilier par un vide.
